# EUROPEAN PATENT APPLICATION

(11) **EP 4 546 396 A1**
(43) Date of publication of application: **30.04.2025**
(21) Application number: 23831197.1
(22) Date of filing: 20.06.2023
(51) Int. Cl.: H01L 21/304, B24B 37/00, C09G 1/02, C09K 3/14

(54) **POLISHING MATERIAL SLURRY AND POLISHING METHOD OF SAME**

(30) Priority: 27.06.2022 JP 2022102367
(71) Applicant: Mitsui Mining & Smelting Co., Ltd, Shinagawa-ku Tokyo 141-8584 (JP)
(72) Inventor: NAKAMURA, Takuma, Omuta-shi, Fukuoka 836-0003 (JP); SARUWATARI, Yasunobu, Omuta-shi, Fukuoka 836-0003 (JP)
(74) Representative: Novagraaf Technologies
(86) International application number: PCT/JP2023/022708
(87) International publication number: WO 2024/004751

(57) **Abstract**

An abrasive slurry of the present invention includes manganese oxide abrasive grains containing manganese oxide particles, permanganate ions, phosphates, and a polymeric additive containing one or more water-soluble organic polymers selected from the group consisting of a polycarboxylic acid, a polycarboxylate, a salt of naphthalene sulfonic acid formalin condensate, polyvinyl alcohol, polyethylene glycose, polyvinylpyrrolidone, and copolymers thereof. Furthermore, in a polishing method of the abrasive slurry of the present invention, an object to be polished is polished using the abrasive slurry of the present invention.

## Description

### Technical Field

The present invention relates to an abrasive slurry and a polishing method of the same.

### Background Art

Among semiconductor devices, a power semiconductor device, a so-called power device, requires an increase in withstand voltage and an increase in current, which are achieved by using silicon carbide (SiC), gallium nitride, diamond, or the like instead of silicon that has been conventionally used as a substrate. Since the substrates formed of these materials have a larger band gap than a conventional silicon substrate, the substrates can withstand a higher voltage.

Among them, a substrate formed of silicon carbide (hereinafter, the substrate is referred to as a SiC substrate) is not only excellent in hardness, heat resistance, and scientific stability, but also excellent in terms of cost. On the other hand, since a SiC substrate has higher hardness than that of a conventional silicon substrate, an abrasive slurry containing manganese oxide particles as abrasive grains disclosed in, for example, Patent Literature 1 has been developed as an abrasive slurry used in a step of finishing the surface of the SiC substrate to a mirror surface, which is a polishing step performed by a so-called chemical mechanical polishing (CMP) method or the like, among the SiC substrate production steps.

### Citation List

### Patent Literature

Patent Literature 1: JP 2017-071787 A

### Summary of Invention

### Technical Problem

However, since the abrasive slurry containing manganese oxide particles as abrasive grains as disclosed in Patent Literature 1 often has insufficient dispersibility, and the abrasive slurry is in a thick liquid state, there is a problem that the supply tube for supplying the abrasive slurry is easily clogged. In addition, during the polishing treatment, the abrasive slurry adheres to the surface of the SiC substrate which is an object to be polished or a device such as a polishing pad used for polishing, causing the abrasive slurry to be hardly removed even when the polishing pad or the SiC substrate is cleaned after the polishing treatment, and the cleaning treatment to be time-consuming. Such an abrasive slurry has shown a tendency to have a short pot life.

In view of the above problems, an object of the present invention is to provide an abrasive slurry which is excellent in dispersibility, exhibits a high polishing rate, and has a long pot life and a polishing method.

### Solution to Problem

An abrasive slurry of the present invention that has been developed to solve the above problems includes manganese oxide abrasive grains containing manganese oxide particles, permanganate ions, phosphates, and a polymeric additive containing one or more water-soluble organic polymers selected from the group consisting of a polycarboxylic acid, a polycarboxylate, a salt of naphthalene sulfonic acid formalin condensate, polyvinyl alcohol, polyethylene glycose, polyvinylpyrrolidone, and copolymers thereof.

Since the abrasive slurry of the present invention includes the manganese oxide abrasive grains containing the manganese oxide particles, the permanganate ions, the phosphates, and the polymeric additive containing one or more water-soluble organic polymers selected from the group consisting of a polycarboxylic acid, a polycarboxylate, a salt of naphthalene sulfonic acid formalin condensate, polyvinyl alcohol, polyethylene glycose, polyvinylpyrrolidone, and copolymers thereof, the abrasive slurry is excellent in dispersibility, exhibits a high polishing rate, and has a long pot life.

In addition, since the abrasive slurry according to the present invention is excellent in dispersibility, it leads to a reduction in environmental load from the viewpoint that a SiC substrate which is an object to be polished and a polishing pad are easily cleaned, and the amount of cleaning water used can be reduced, the viewpoint that the cleaning time can be shortened, and the viewpoint of that the amount of wastewater treated can be reduced. Furthermore, since the abrasive slurry according to the present invention exhibits a high polishing rate, the polishing treatment time can be shortened.

Examples of the manganese oxide particles contained in the manganese oxide abrasive grains include manganese (II) oxide (MnO), dimanganese (III) trioxide (Mn₂O₃), manganese (IV) dioxide (MnO₂), and trimanganese (II, III) tetraoxide (Mn₃O₄). The manganese oxide abrasive grains may be one kind or a mixture of two or more kinds of the manganese oxide particles.

In addition, the manganese oxide abrasive grains may contain abrasive grains other than the manganese oxide particles described above as long as the effect of preventing warpage and cracking due to the Twyman effect exerted on, for example, the SiC substrate, which is an object to be polished by the abrasive slurry of the present invention, is not impaired. Examples of the abrasive grains other than the manganese oxide particles include a compound such as an oxide, a hydroxide, or a carbide of at least one element selected from Mg, B, Si, Ce, Al, Zr, Fe, Ti, and Cr, and other carbon materials. Specific examples of the abrasive grains other than the manganese oxide particles include alumina, silica, cerium oxide, zirconium oxide, titanium oxide, chromium oxide, iron oxide, magnesium hydroxide, cerium hydroxide, silicon carbide, boron carbide, and diamond. These may be used singly or in combination of two or more kinds thereof. In addition, the manganese oxide particles may be combined with the abrasive grains other than the manganese oxide particles. For example, the surfaces of the manganese oxide particles may be coated with the abrasive grains other than the manganese oxide particles, or the surfaces of the abrasive grains other than the manganese oxide particles may be coated with the manganese oxide particles.

In addition, the particle size of the manganese oxide abrasive grains at a cumulative volume of 50% (D50), which is measured by a laser diffraction/scattering particle size distribution measurement method, is preferably 0.1 µm or more from the viewpoint of having a high polishing force, and is preferably 5.0 µm or less from the viewpoint of preventing roughness of the surface of the object to be polished, for example, a SiC substrate. Therefore, the particle size of the manganese oxide abrasive grains at a cumulative volume of 50% (D50), which is measured by a laser diffraction/scattering particle size distribution measurement method, is more preferably 0.15 µm or more and 4.5 µm or less and even more preferably 0.2 µm or more and 4.0 µm or less.

Here, for the particle size of the manganese oxide abrasive grains at a cumulative volume of 50% (D50), which is measured by a laser diffraction/scattering particle size distribution measurement method, a measurement sample is prepared in a production method for the abrasive slurry of the present invention described later by obtaining a mixture by pulverizing the manganese oxide abrasive grains using beads and diluting the mixture with water so that the concentration of the mixture becomes about 0.01%. Then, measurement is performed using a laser diffraction/scattering method particle size distribution measuring apparatus (MT3300EXII manufactured by MicrotracBEL Corp.).

Furthermore, the content of the manganese oxide abrasive grains contained in the abrasive slurry of the present invention is preferably 0.5 mass% or more and 20 mass% or less and more preferably 0.5 mass% or more and 10 mass% or less with respect to the total amount of the polishing slurry from the viewpoint of sufficiently increasing the polishing rate of a high hardness material such as silicon carbide, the viewpoint of securing suitable fluidity of the abrasive grains in the polishing slurry, the viewpoint of preventing aggregation, and the like. In addition, the content of the manganese oxide particles contained in the manganese oxide abrasive grains is more preferably 1 mass% or more and 5 mass% or less from the viewpoint of sufficiently increasing the polishing rate. In the present specification, the content in the abrasive slurry of the present invention is the content in the polishing slurry before the start of polishing unless otherwise specified.

The abrasive slurry of the present invention also includes permanganate ions (MnO₄⁻) in addition to the manganese oxide abrasive grains described above. The permanganate ions act as an oxidizing agent, and when used in combination with the manganese oxide abrasive grains, the permanganate ion can have a high polishing force with respect to a high hardness material such as silicon carbide. Here, the supply source of the permanganate ions is preferably permanganate. Examples of the permanganate include an alkali metal salt of permanganic acid and an alkaline earth metal salt of permanganic acid. Furthermore, from the viewpoint of easy availability and the viewpoint of improving the polishing efficiency of the abrasive slurry of the present invention, among the permanganates as a supply source of the permanganate ions, an alkali metal salt of permanganic acid is preferable, and sodium permanganate or potassium permanganate is more preferable. These permanganates may be used singly or in combination of two or more kinds thereof.

In addition, the content of the permanganate ions in the abrasive slurry of the present invention is preferably **0.5** mass% or more with respect to the total amount of the abrasive slurry of the present invention from the viewpoint of sufficiently increasing the polishing rate. In addition, the content of the permanganate ions in the abrasive slurry of the present invention is preferably 3.2 mass% or less with respect to the total amount of the abrasive slurry of the present invention from the viewpoint of preventing crystal precipitation due to an increase in the addition amount, the viewpoint of ensuring the safety in handling of the abrasive slurry, the viewpoint that the polishing rate tends to be saturated even when the addition amount is increased, and the like. That is, the content of the permanganate ions is preferably 0.5 mass% or more and 3.2 mass% or less and more preferably 1.0 mass% or more and 2.1 mass% or less with respect to the total amount of the abrasive slurry of the present invention. The content of the permanganate ions is measured by ion chromatography or absorptiometry.

The abrasive slurry of the present invention further includes phosphates in addition to the manganese oxide abrasive grains and the permanganate ions described above. When phosphates are used in combination with the manganese oxide abrasive grains and the permanganate ions, dispersibility of the abrasive slurry of the present invention can be improved.

The phosphates contained in the abrasive slurry of the present invention are preferably, for example, inorganic phosphorus compounds. Specific examples of the inorganic phosphorus compounds include phosphate compounds such as a sodium phosphate (trisodium phosphate (anhydrous) (Na₃PO₄), CAS number: 7601-54-9; trisodium phosphate·dodecahydrate (Na₃PO₄·12H₂O), CAS number: 10101-89-0; monobasic sodium phosphate (NaH₂PO₄), CAS number: 7558-80-7; and dibasic sodium phosphate (Na₂HPO₄), CAS number: 7558-79-4) and a potassium phosphate (tripotassium phosphate (anhydrous) (K₃PO₄), CAS number: 7778-53-2; tripotassium phosphate·monohydrate (K₃PO₄·H₂O), CAS number: 27176-10-9; dibasic potassium phosphate·trihydrate (K₂HPO₄·H₂O), CAS number: 16788-57-1; monobasic potassium phosphate (KH₂PO₄). CAS number: 7778-77-0; and dipotassium phosphate (K₂HPO₄), CAS number: 7758-11-4).

Moreover, examples of a metaphosphate compound include sodium metaphosphate (NaPO₃)ₙ, CAS number: 35270-09-8) and potassium metaphosphate (KPO₃)ₙ, CAS number: 7790-53-6.

Examples of a hexametaphosphate compound include sodium hexametaphosphate (NaH₇P₆O₁₈), CAS number: 10124-56-8.

Examples of a pyrophosphate compound include a sodium pyrophosphate (sodium pyrophosphate (anhydrous) (Na₄P₂O₇), CAS number: 7722-88-5; sodium pyrophosphate·decahydrate (Na₄P₂O₇·10H₂O), CAS number: 13472-36-1; and sodium acid pyrophosphate (Na₂H₂P₂O₇), CAS number: 7758-16-9), and potassium pyrophosphate (K₄P₂O₇), CAS number: 7320-34-5.

Examples of a polyphosphate compound include sodium polyphosphate (Na₃P₃O₁₀X₂), CAS number: 68915-31-1; and potassium polyphosphate (K₃P₃O₁₀X₂), CAS number: 68956-75-2.

Examples of a tripolyphosphate compound include sodium tripolyphosphate (Na₅P₃O₁₀), CAS number: 7758-29-4 and potassium tripolyphosphate (K₅P₃O₁₀), CAS number: 13845-36-8.

The examples also include salts and hydrates of these compounds. In the case of the salts of these compounds, alkali metal salts and alkaline earth metal salts are preferable, and particularly sodium salts and potassium salts are more preferable. In particular, in the abrasive slurry of the present invention, from the viewpoint of effective high dispersibility in a small amount and the viewpoint of sufficiently increasing the polishing rate, a metaphosphate compound, a hexametaphosphate compound, a pyrophosphate compound (sodium pyrophosphate or potassium pyrophosphate), a polyphosphate compound (sodium polyphosphate or potassium polyphosphate), and a tripolyphosphate compound are more preferable. These phosphates may be used singly or in combination of two or more kinds thereof.

Furthermore, among the inorganic phosphorus compounds described above, a pyrophosphate compound is preferable from the viewpoint of high dispersibility and the viewpoint of sufficiently increasing the polishing rate. The pyrophosphate compound is more preferably an alkali metal salt of pyrophosphoric acid or an alkaline earth metal salt of pyrophosphoric acid, and particularly preferably sodium pyrophosphate or potassium pyrophosphate.

In addition, the content of the phosphates in the abrasive slurry of the present invention is preferably 0.001 mass% or more with respect to the total amount of the abrasive slurry of the present invention from the viewpoint of dispersibility. In addition, the content of the phosphates in the abrasive slurry of the present invention is preferably 0.1 mass% or less with respect to the total amount of the abrasive slurry of the present invention from the viewpoint that the polishing rate tends to be saturated even when the addition amount is increased. That is, the content of the phosphates is preferably 0.001 mass% or more and 0.1 mass% or less with respect to the total amount of the abrasive slurry of the present invention, more preferably 0.002 mass% or more from the viewpoint of improving the dispersibility, and more preferably 0.05 mass% or less from the viewpoint of sufficiently increasing the polishing rate. In the present specification, the content of the phosphates is the total amount of those classified as phosphates unless otherwise specified.

Furthermore, the content of the phosphates in the abrasive slurry of the present invention is preferably 0.05% or more and 5.0% or less, more preferably 0.07% or more and 3.0% or less, and even more preferably 0.1% or more and 2.0% or less when expressed as a mass ratio with respect to the content of the manganese oxide abrasive grains in the abrasive slurry of the present invention.

In addition, the abrasive slurry of the present invention also includes a polymeric additive containing one or more water-soluble organic polymers selected from the group consisting of a polycarboxylic acid, a polycarboxylate, a salt of naphthalene sulfonic acid formalin condensate, polyvinyl alcohol, polyethylene glycose, polyvinylpyrrolidone, and copolymers thereof, in addition to the manganese oxide abrasive grains, the permanganate ions, and the phosphates described above. By containing the polymeric additive described above, the pot life of the abrasive slurry of the present invention can be extended.

The water-soluble organic polymer described above preferably has a number average molecular weight (Mn) of 1000 or more and 10000 or less, a weight average molecular weight (Mw) of 1000 or more and 1000000 or less, a z average molecular weight (Mz) of 5000 or more and 1000000 or less, a dispersion degree (Mw/Mn), which is a ratio between Mw and Mn, of 0.1 or more and 150 or less, and a ratio of Mz to Mw (Mz/Mw) of 0.1 or more and 20 or less, in terms of polyethylene glycol (PEG) as measured by gel permeation chromatography (GPC). Here, the number average molecular weight (Mn) is more preferably 2000 or more and 8000 or less. Typically, the number average molecular weight (Mn) may be 3000 or more and 6000 or less. The weight average molecular weight (Mw) is more preferably 3500 or more and 100000 or less and even more preferably 4000 or more and 50000 or less. Typically, the weight average molecular weight (Mw) may be 5000 or more and 20000 or less. The z average molecular weight (Mz) is more preferably 6000 or more and 100000 or less. Typically, the z average molecular weight (Mz) may be 6500 or more and 75000 or less, or 7000 or more and 50000 or less. The dispersion degree (Mw/Mn) is more preferably 0.5 or more and 75 or less and even more preferably 0.8 or more and 10 or less. Typically, the dispersion degree (Mw/Mn) may be 0.9 or more and 5. The ratio of Mz to Mw (Mz/Mw) is more preferably 0.5 or more and 15 or less and even more preferably 0.8 or more and 10 or less. Typically, the ratio of Mz to Mw (Mz/Mw) may be 0.9 or more and 5 or less. Meanwhile, when carboxymethyl cellulose (CMC) was included as the polymeric additive, the pot life of the abrasive slurry was short as described later.

Here, the number average molecular weight (Mn), the weight average molecular weight (Mw), and the z average molecular weight (Mz) in terms of polyethylene glycol (PEG) as measured by GPC can be measured and analyzed under the following conditions. In addition, the dispersion degree (Mw/Mn) and the ratio of Mz to Mw (Mz/Mw) are calculated from the obtained number average molecular weight (Mn), weight average molecular weight (Mw), and z average molecular weight (Mz).

### =Conditions for Measurement of Molecular Weight=

Measuring apparatus: HPLC Prominence series (manufactured by SHIMADZU CORPORATION)
Apparatus configuration: CBM20A, DGU-20A3R, LC-20AD, SIL-20ACHT, CTO-20AC, and RID-10A
Column: Shodex OHpak SB-803 HQ (manufactured by Resonac Corporation)
Temperature: 40°C
Flow rate: 1.0 ml/min
Detector: Indication refractive index detector
Eluent: 0.1M aqueous sodium chloride solution

### =Analysis Software=

Software: LabSolutions/LCsolution GPC (manufactured by SHIMADZU CORPORATION)
Version: 1.25 SP2

Furthermore, when the aqueous solution obtained by dissolving the above-described water-soluble organic polymer in water has a high viscosity, it is difficult to measure each molecular weight by GPC described above. In this case, the aqueous solution containing 1 mass% of the water-soluble organic polymer preferably has a viscosity of 10000 mPa·s or more and 30000 mPa·s or less at a liquid temperature of 25°C. Typically, the viscosity may be 11000 mPa·s or more and 27000 mPa·s or less, 12000 mPa·s or more and 24000 mPa·s or less, or 13000 mPa·s or more and 21000 mPa·s or less. The viscosity of the water-soluble organic polymer is measured by a digital rotational viscometer DV3T (manufactured by EKO INSTRUMENTS CO., LTD.) under the condition of a rotation speed of 0.01 rpm.

In the abrasive slurry of the present invention, the polymeric additive is more preferably one or more water-soluble organic polymers selected from a polycarboxylic acid, a polycarboxylate, and copolymers thereof, the polymeric additive is even more preferably one or more water-soluble organic polymers selected from polyacrylic acid, polymaleic acid, a polyacrylate, a polymaleate, and copolymers thereof, the polymeric additive is particularly preferably a polyacrylate, and the polymeric additive is more particularly preferably ammonium polyacrylate.

In addition, the content of the polymeric additive in the abrasive slurry of the present invention is preferably 0.006 mass% or more with respect to the total amount of the abrasive slurry of the present invention from the viewpoint of dispersibility. Furthermore, the content of the polymeric additive in the abrasive slurry of the present invention is preferably 0.05 mass% or less with respect to the total amount of the abrasive slurry of the present invention from the viewpoint of sufficiently increasing the polishing rate. That is, the content of the polymeric additive is preferably 0.006 mass% or more and 0.05 mass% or less and more preferably 0.01 mass% or more and 0.03 mass% or less with respect to the total amount of the abrasive slurry of the present invention. In the present specification, the content of the polymeric additive is the total amount of those classified as the polymeric additive described above unless otherwise specified.

Furthermore, the content of the polymeric additive in the abrasive slurry of the present invention is preferably 0.3% or more and 2.5% or less, more preferably 0.4% or more and 2.0% or less, and even more preferably 0.5% or more and 1.0% or less when expressed as a mass ratio with respect to the content of the manganese oxide abrasive grains in the abrasive slurry of the present invention.

In addition, in the abrasive slurry of the present invention, the content of the manganese oxide abrasive grains is 0.5 mass% or more and 20 mass% or less, the content of the permanganate ions is 0.5 mass% or more and 3.2 mass% or less, the content of the phosphates is 0.001 mass% or more and 0.1 mass% or less, and the content of the polymeric additive is 0.006 mass% or more and 0.05 mass% or less.

It is preferable that, in the abrasive slurry of the present invention, the content of the manganese oxide abrasive grains is 0.5 mass% or more and 20 mass% or less, the content of the permanganate ions is 0.5 mass% or more and 3.2 mass% or less, the content of the phosphates is 0.001 mass% or more and 0.1 mass% or less, and the content of the polymeric additive is 0.006 mass% or more and 0.05 mass% or less as described above, from the viewpoint of being excellent in dispersibility, exhibiting a high polishing rate, and having a long pot life.

Here, the abrasive slurry of the present invention includes a dispersion medium for dissolving or dispersing the manganese oxide abrasive grains, the permanganate ions, the phosphates, and the polymeric additive described above. The dispersion medium is preferably water or a water-soluble organic solvent such as an alcohol or a ketone, or a mixture thereof from the viewpoint of sufficiently increasing the polishing rate, and more preferably water. The content of the dispersion medium is preferably 60 mass% or more and 99.9 mass% or less and more preferably 80 mass% or more and 90 mass% or less with respect to the total amount of the abrasive slurry.

The abrasive slurry of the present invention may further include a certain additive other than the manganese oxide abrasive grains, the permanganate ions, the phosphates, the polymeric additive, and the dispersion medium described above. Here, the certain additive is a dispersant, a pH adjusting agent, a viscosity adjusting agent, a chelating agent, a rust inhibitor, or the like. The content of the certain additive is preferably 40 mass% or less, more preferably 20 mass% or less, and even more preferably 10 mass% or less with respect to the total amount of the abrasive slurry of the present invention.

The abrasive slurry of the present invention can include the above-described manganese oxide abrasive grains, permanganate ions, phosphates, polymeric additive, dispersion medium, and a certain additive in an appropriately mixed form. For example, the abrasive slurry may be prepared as a kit in which these components are divided into two or more agents. The kit may be configured in any manner as long as the polishing ability is sufficiently exhibited when the abrasive slurry is adjusted.

A polishing method for polishing an object to be polished using the above-described abrasive slurry of the present invention will be described below.

Examples of the polishing method include a polishing method in which the abrasive slurry of the present invention is supplied to a polishing pad, the surface to be polished on the object to be polished is brought into contact with the polishing pad, and polishing is performed by relative movement between the surface to be polished and the polishing pad. Here, a method of pouring the abrasive slurry of the present invention, or a method of circulating the abrasive slurry of the present invention in which an operation of collecting the abrasive slurry of the present invention supplied to the polishing pad and used for the polishing and supplying the collected abrasive slurry of the present invention to the polishing pad again is repeated may be performed. Since the abrasive slurry of the present invention can circulate and repeatedly polish the object to be polished, the amount of the abrasive slurry used can be reduced. Here, as the polishing pad, for example, a conventionally used nonwoven fabric, a pad obtained by impregnating the nonwoven fabric with a resin such as polyurethane or epoxy, a suede material, or the like can be used. The polishing pressure is preferably 0.5 × 10⁴ Pa or more and 1.0 × 10⁵ Pa or less, particularly 1.0 × 10⁴ Pa or more and 5.0 × 10⁴ Pa or less from the viewpoint of a polishing force, ease of handling a polishing jig, and the like. The supply amount of the abrasive slurry is preferably 10 mL/min or more and 500 mL/min or less, and more preferably 50 mL/min or more and 250 mL/min or less.

The object to be polished which is polished by the abrasive slurry of the present invention is, for example, a high hardness material having a Mohs hardness of 8 or more. Here, the Mohs hardness is obtained by quantifying the hardness based on how a material is scratched by a reference material, and can be measured by a conventional method using a Mohs Scale of Hardness. As the Mohs hardness, reference materials from 1 to 10 are specified in order from a softer material, and the specific reference materials are as follows: Mohs hardness 1 is talc, 2 is gypsum, 3 is calcite, 4 is fluorite, 5 is apatite, 6 is orthoclase, 7 is quartz, 8 is topaz, 9 is corundum, and 10 is diamond. Examples of the high hardness material having a Mohs hardness of 8 or more include silicon carbide (Mohs hardness of about 9), gallium nitride (Mohs hardness of about 9), and diamond.

The abrasive slurry of the present invention can be used in a finishing chemical mechanical polishing (CMP) process or the like after wrapping of a substrate formed of a high hardness material. In particular, the abrasive slurry of the present invention can be used for polishing a substrate formed of silicon carbide (SiC), that is, a SiC substrate, and can sufficiently increase the polishing rate and effectively prevent the occurrence of warpage and cracking due to the Twyman effect. As the SiC substrate, a monocrystalline silicon carbide substrate is usually used, and examples of the crystal system thereof usually include hexagonal crystals and rhombohedral crystals. From the viewpoint of exerting the effect of the abrasive slurry which is the ability to prevent the occurrence of warpage and cracking due to the Twyman effect, hexagonal crystals are preferable. Examples of the hexagonal polymorph include 2H, 4H, 6H, 8H, and 10H. Examples of the rhombohedral polymorph include 15R.

Next, a method for producing the above-described abrasive slurry of the present invention will be described below.

First, pure water, manganese dioxide (abrasive grains, MnO₂), phosphates (for example, sodium salt of pyrophosphoric acid), a polymeric additive containing one or more water-soluble organic polymers selected from the group consisting of a polycarboxylic acid, a polycarboxylate, a salt of naphthalene sulfonic acid formalin condensate, polyvinyl alcohol, polyethylene glycose, polyvinylpyrrolidone, and copolymers thereof, and beads (zirconia, φ 0.4 mm) are placed in a container, the container is set on a paint shaker (60 Hz), and the container is rotated at a high speed, thus mixing and pulverizing the manganese dioxide (abrasive grains, MnO₂).

Using a centrifuge (himac CT 6E manufactured by Hitachi Koki Co., Ltd.) or the like, the beads are separated from the mixture in the container containing the manganese dioxide (abrasive grains, MnO₂) which has been mixed and pulverized, and the supernatant is collected.

The solid content concentration, that is, the concentration of the manganese oxide abrasive grains in the collected supernatant is measured with a heating type aquameter, and pure water is added to a predetermined concentration to obtain an abrasive slurry intermediate.

Then, the abrasive slurry intermediate and potassium permanganate (KMnO₄) are mixed to obtain the abrasive slurry of the present invention.

Note that, in the present specification, the expression "X to Y" (X and Y are any numbers) encompasses the meaning of "preferably larger than X" or "preferably smaller than Y" as well as the meaning of "X or more and Y or less", unless otherwise specified. In addition, the expression "X or more" (X is any number) or "Y or less" (Y is any number) encompasses the intention of "preferably greater than X" or "preferably less than Y".

### Advantageous Effects of Invention

The abrasive slurry of the present invention is excellent in dispersibility, can sufficiently increase the polishing rate, and has a long pot life.

### Brief Description of Drawings

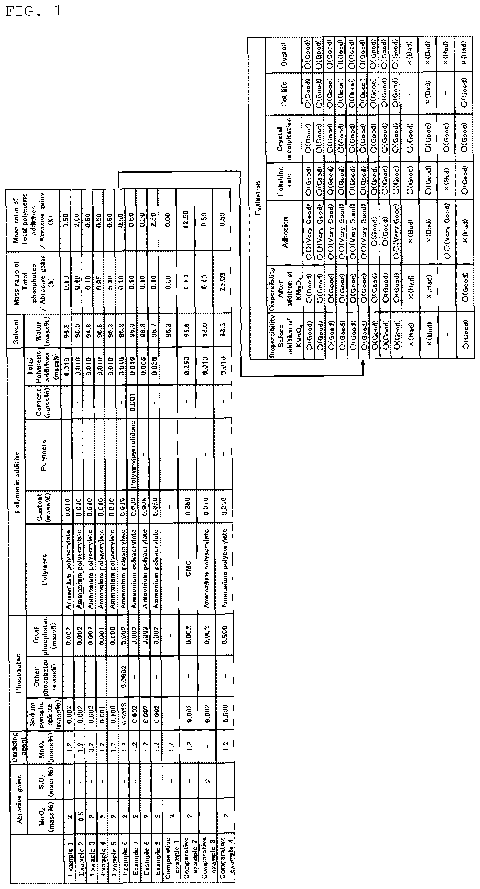

Fig. 1 is a list of physical property values and measurement results of abrasive slurries according to Examples 1 to 9 and Comparative Examples 1 to 5.

### Best Mode for Carrying Out the Invention

Hereinafter, the abrasive slurry of an embodiment according to the present invention will be further described based on the following Examples. However, the following Examples do not limit the present invention.

### (Example 1)

Pure water, manganese dioxide (MnO₂) as abrasive grains, sodium pyrophosphate (specifically, sodium pyrophosphate·decahydrate (Na₄P₂O₇·10H₂O), CAS number: 13472-36-1) as phosphates, ammonium polyacrylate (number average molecular weight (Mn): 5500, weight average molecular weight (Mw): 7500, z average molecular weight (Mz): 9200, dispersion degree (Mw/Mn): 1.4, and ratio of Mz to Mw (Mz/Mw): 1.2) as a polymeric additive, and beads (zirconia, φ 0.4 mm) were placed in a container, the container was set on a paint shaker (60 Hz), and the container was rotated at a high speed, thus mixing and pulverizing the manganese dioxide. The contents of these components were prepared so that the content of the manganese dioxide was 30 mass%, the content of the sodium pyrophosphate was 0.03 mass%, and the content of the ammonium polyacrylate was 0.01 mass% with respect to the total amount of an abrasive slurry according to Example 1.

Using a centrifuge ((himac CT 6E manufactured by Hitachi Koki Co., Ltd.) or the like, the beads were separated from the mixture in the container containing the manganese dioxide which had been mixed and pulverized, and the supernatant was collected. The supernatant obtained in this step serves as a measurement sample before addition of potassium permanganate in the dispersibility test described later.

The solid content concentration, that is, the concentration of the manganese oxide abrasive grains in the collected supernatant was measured with a heating type aquameter, and pure water was added to a predetermined concentration to obtain an abrasive slurry intermediate.

Then, the abrasive slurry intermediate and an aqueous potassium permanganate (KMnO₄) solution having a KMnO₄ mass% concentration of 3.2 mass% were mixed to obtain the abrasive slurry according to Example 1. The content of permanganate ions was prepared to be 1.2 mass% with respect to the total amount of the abrasive slurry according to Example 1. Furthermore, the mass ratio of the total content of the phosphates to the content of the manganese oxide abrasive grains according to Example 1 was 0.10%. In addition, the mass ratio of the total content of the polymeric additive to the content of the manganese oxide abrasive grains according to Example 1 was 0.50%. Note that the abrasive slurry according to Example 1 obtained in this step serves as a measurement sample after addition of potassium permanganate in the dispersibility test described later. In addition, the composition of the abrasive slurry shown in Fig. 1 is the composition in the final product.

### (Example 2)

In Example 2, an abrasive slurry according to Example 2 was obtained by performing the same production method as in Example 1, except that the content of manganese dioxide was prepared to be 0.5 mass% with respect to the total amount of the abrasive slurry according to Example 2. The mass ratio of the total content of the phosphates to the content of the manganese oxide abrasive grains according to Example 2 was 0.40%. In addition, the mass ratio of the total content of the polymeric additive to the content of the manganese oxide abrasive grains according to Example 2 was 2.00%.

### (Example 3)

In Example 3, an abrasive slurry according to Example 3 was obtained by performing the same production method as in Example 1, except that the abrasive slurry intermediate was mixed with an aqueous potassium permanganate (KMnO₄) solution having a KMnO₄ mass% concentration of 5.6 mass%, and the content of the permanganate ions was prepared to be 3.2 mass% with respect to the total amount of the abrasive slurry according to Example 3. The mass ratio of the total content of the phosphates to the content of the manganese oxide abrasive grains according to Example 3 was 0.10%. In addition, the mass ratio of the total content of the polymeric additive to the content of the manganese oxide abrasive grains according to Example 3 was 0.50%.

### (Example 4)

In Example 4, an abrasive slurry according to Example 4 was obtained by performing the same production method as in Example 1, except that the content of the sodium pyrophosphate was prepared to be 0.001 mass% with respect to the total amount of the abrasive slurry according to Example 4. The mass ratio of the total content of the phosphates to the content of the manganese oxide abrasive grains according to Example 4 was 0.05%. In addition, the mass ratio of the total content of the polymeric additive to the content of the manganese oxide abrasive grains according to Example 4 was 0.50%.

### (Example 5)

In Example 5, an abrasive slurry according to Example 5 was obtained by performing the same production method as in Example 1, except that the content of the sodium pyrophosphate was prepared to be 0.1 mass% with respect to the total amount of the abrasive slurry according to Example 5. The mass ratio of the total content of the phosphates to the content of the manganese oxide abrasive grains according to Example 5 was 5.00%. In addition, the mass ratio of the total content of the polymeric additive to the content of the manganese oxide abrasive grains according to Example 5 was 0.50%.

### (Example 6)

In Example 6, an abrasive slurry according to Example 6 was obtained by performing the same production method as in Example 1, except that the content of the sodium pyrophosphate was prepared to be 0.0018 mass%, and the content of other phosphates (specifically, a sample obtained by mixing each of tripotassium phosphate (anhydrous) (K₃PO₄), CAS number: 7778-53-2, sodium metaphosphate (NaPO₃)ₙ, CAS number: 35270-09-8, potassium pyrophosphate (K₄P₂O₇), CAS number: 7320-34-5, sodium polyphosphate (Na₃P₃O₁₀X₂), CAS number: 68915-31-1, and sodium tripolyphosphate (Na₅P₃O₁₀), CAS number: 7758-29-4 in equal amounts) were prepared to be 0.0002 mass%, with respect to the total amount of the abrasive slurry according to Example 6. The mass ratio of the total content of the phosphates to the content of the manganese oxide abrasive grains according to Example 6 was 0.10%. In addition, the mass ratio of the total content of the polymeric additive to the content of the manganese oxide abrasive grains according to Example 6 was 0.50%.

### (Example 7)

In Example 7, an abrasive slurry according to Example 7 was obtained by performing the same production method as in Example 1, except that the content of the ammonium polyacrylate was prepared to be 0.009 mass%, and the content of polyvinylpyrrolidone (polyvinylpyrrolidone K25 manufactured by FUJIFILM Wako Pure Chemical Corporation) (number average molecular weight (Mn): 4100, weight average molecular weight (Mw): 14000, z average molecular weight (Mz): 46000, dispersion degree (Mw/Mn): 3.4, and ratio of Mz to Mw (Mz/Mw): 3.3) was prepared to be 0.001 mass%, with respect to the total amount of the abrasive slurry according to Example 7. The mass ratio of the total content of the phosphates to the content of the manganese oxide abrasive grains according to Example 7 was 0.10%. In addition, the mass ratio of the total content of the polymeric additive to the content of the manganese oxide abrasive grains according to Example 7 was 0.50%.

### (Example 8)

In Example 8, an abrasive slurry according to Example 8 was obtained by performing the same production method as in Example 1, except that the content of the ammonium polyacrylate was prepared to be 0.006 mass% with respect to the total amount of the abrasive slurry according to Example 8. The mass ratio of the total content of the phosphates to the content of the manganese oxide abrasive grains according to Example 8 was 0.10%. In addition, the mass ratio of the total content of the polymeric additive to the content of the manganese oxide abrasive grains according to Example 8 was 0.30%.

### (Example 9)

In Example 9, an abrasive slurry according to Example 9 was obtained by performing the same production method as in Example 1, except that the content of the ammonium polyacrylate was prepared to be 0.05 mass% with respect to the total amount of the abrasive slurry according to Example 9. The mass ratio of the total content of the phosphates to the content of the manganese oxide abrasive grains according to Example 9 was 0.10%. In addition, the mass ratio of the total content of the polymeric additive to the content of the manganese oxide abrasive grains according to Example 9 was 2.50%.

### (Comparative Example 1)

In Comparative Example 1, an abrasive slurry according to Comparative Example 1 was obtained by performing the same manufacturing method as in Example 1, except that the phosphates and the polymeric additive were not added.

### (Comparative Example 2)

In Comparative Example 2, an abrasive slurry according to Comparative Example 2 was obtained by performing the same production method as in Example 1, except that carboxymethyl cellulose (CMC) (number average molecular weight (Mn): 12400, weight average molecular weight (Mw): 2400000, z average molecular weight (Mz): 65000000, dispersion degree (Mw/Mn): 193.5, and ratio of Mz to Mw (Mz/Mw): 27.1) was prepared so that the content thereof was 0.25 mass% with respect to the total amount of the abrasive slurry according to Comparative Example 2, instead of the ammonium polyacrylate used in Example 1. The mass ratio of the total content of the phosphates to the content of the manganese oxide abrasive grains according to Comparative Example 2 was 0.10%. In addition, the mass ratio of the total content of the polymeric additive to the content of the manganese oxide abrasive grains according to Comparative Example 2 was 12.5%.

### (Comparative Example 3)

In Comparative Example 3, an abrasive slurry according to Comparative Example 3 was obtained by performing the same production method as in Example 1, except that silicon dioxide (SiO₂) was prepared so that the content thereof was 2 mass% with respect to the total amount of the abrasive slurry according to Comparative Example 3 instead of manganese dioxide (MnO₂) used in Example 1, and potassium permanganate (KMnO₄) was not added to the abrasive slurry intermediate. The mass ratio of the total content of the phosphates to the content of the silicon oxide abrasive grains according to Comparative Example 3 was 0.10%. In addition, the mass ratio of the total content of the polymeric additive to the content of the silicon oxide abrasive grains according to Comparative Example 3 was 0.50%.

### (Comparative Example 4)

In Comparative Example 4, an abrasive slurry according to Comparative Example 4 was obtained by performing the same production method as in Example 1, except that the content of the sodium pyrophosphate was prepared to be 0.5 mass% with respect to the total amount of the abrasive slurry according to Comparative Example 4. The mass ratio of the total content of the phosphates to the content of the manganese oxide abrasive grains according to Comparative Example 4 was 25.0%. In addition, the mass ratio of the total content of the polymeric additive to the content of the manganese oxide abrasive grains according to Comparative Example 4 was 0.50%.

Then, the following physical property values were measured for the abrasive slurries according to Examples 1 to 9 and Comparative Examples 1 to 4. The physical property values that were measured and the method for measuring the physical property values are shown below, and the measurement results are shown in Fig. 1.

### <Evaluation of Particle Size>

Mixtures containing the abrasive grains in the abrasive slurries according to Examples 1 to 9 and Comparative Examples 1 to 4 which were mixed and pulverized by a paint shaker were diluted with water so that the concentrations of the mixtures were about 0.01%, thus preparing measurement samples. Then, the particle size (D50) at a volume-based cumulative fraction of 50% was measured using a laser diffraction/scattering method particle size distribution measuring apparatus (MT3300EXII manufactured by MicrotracBEL Corp.).

### <Evaluation of Dispersibility>

The dispersibility of the abrasive slurries according to Examples 1 to 9 and Comparative Examples 1, 2, and 4 was evaluated before and after addition of potassium permanganate as a supply source of the permanganate ions, respectively.

First, the dispersibility before the addition of potassium permanganate was evaluated as follows. Mixtures containing the abrasive grains in the abrasive slurries according to Examples 1 to 9 and Comparative Examples 1, 2, and 4 which were mixed and pulverized by a paint shaker were diluted with water so that the concentrations of the mixtures were about 0.01 mass%, thus preparing measurement samples. Then, the particle size (D50) at a volume-based cumulative fraction of 50% was measured using a laser diffraction/scattering method particle size distribution measuring apparatus (MT3300EXII manufactured by MicrotracBEL Corp.), and when D50 was 0.6 µm or less, it was evaluated as "○ (Good)", and when D50 was more than 0.6 µm, it was evaluated as "× (Bad)".

Next, the dispersibility after the addition of potassium permanganate was evaluated as follows. Measurement samples were prepared by diluting the abrasive slurries according to Examples 1 to 9 and Comparative Examples 1, 2, and 4 with water so that the concentrations of the abrasive slurries were about 0.01 mass%. Then, the particle size (D50) at a volume-based cumulative fraction of 50% was measured using a laser diffraction/scattering method particle size distribution measuring apparatus (MT3300EXII manufactured by MicrotracBEL Corp.), and when D50 was 0.6 µm or less, it was evaluated as "○ (Good)", and when D50 was more than 0.6 µm, it was evaluated as "× (Bad)". Since potassium permanganate (KMnO₄) was not added to the abrasive slurry intermediate of the abrasive slurry according to Comparative Example 3, the evaluation of dispersibility described above was not performed.

### <Evaluation of Adhesion>

As for the adhesion of the abrasive slurries according to Examples 1 to 9 and Comparative Examples 1 to 4, when a container (250-ml wide-mouth bottle I-BOY manufactured by AS ONE CORPORATION) containing the sample used in the evaluation of dispersibility after the addition of potassium permanganate described above was inverted, the state of adhesion of each abrasive slurry to the container was visually confirmed by the examiner and judged as follows. When the container containing the sample was inverted, it was evaluated as "○○ (Very Good)" if the sample did not adhere to the container, it was evaluated as"○ (Good)" if the sample adhered only to the bottom of the container, and it was evaluated as "× (Bad)" if the sample adhered to the bottom and the side surface or the side surface of the container. For the abrasive slurry according to Comparative Example 3, the abrasive slurry intermediate to which potassium permanganate (KMnO₄) was not added was used as a sample.

### <Polishing Test>

The polishing rates of the abrasive slurries according to Example 1 to 9 and Comparative Example 1 to 4 were evaluated by the following procedure. As an object to be polished, a 4H-SiC substrate that has a diameter of 4 inches and an off angle of 4° and had been subjected to CMP processing was used. The polishing test was performed on the Si surface of the substrate. As a polishing apparatus, a single-side polishing machine BC-15 manufactured by MAT Co., LTD. was used. As a polishing pad attached to the surface plate, IC1000 manufactured by NITTA DuPont Incorporated was used. The rotation speed of the surface plate was set to 60 rpm, and the outer peripheral speed was set to 7,136 cm/min. The carrier rotation speed was set to 60 rpm, and the outer peripheral speed was set to 961 cm/min. Furthermore, the load at the time of polishing was 2.8 psi (about 1.96 × 10⁴ Pa). The supply amount of the abrasive slurry was set to 200 mL/min, polishing was performed for 1 hour, and the polishing rate was determined from the difference in the mass of the substrate which was the object to be polished before and after the polishing. When the polishing rate was 0.10 µm/h or more, it was evaluated as "○ (Good)", and when the polishing rate was less than 0.10 µm/h, it was evaluated as "× (Bad)".

### <Crystal Precipitation Test>

Each of samples of Examples 1 to 9 and Comparative Examples 1 to 4 was prepared. Each of the adjusted samples was stored in a refrigerator set at 10°C for 24 hours. Thereafter, each sample was taken out from the refrigerator, and the solid content concentration in each sample, that is, the total value of the concentration of the manganese oxide abrasive grains and the concentration of potassium permanganate was determined using a heating type aquameter. When the solid content concentration after the storage was 90% or more of the rate of retaining the solid content concentration before the storage, it was evaluated as "○ (Good)", and when the solid content concentration after the storage was less than 90% of the rate of retaining the solid content concentration before the storage, it was evaluated as "× (Bad)".

### <Evaluation of Pot Life>

The pot lives of Examples 1 to 9 and Comparative Examples 1 to 4 were evaluated as follows. The abrasive slurries according to Examples 1 to 9 and Comparative Examples 1 to 4 were allowed to stand at normal temperature (25°C) for 3 days. The MnO₄⁻ concentrations in the abrasive slurries after standing for 3 days were compared with the MnO₄⁻ concentrations in the abrasive slurries before standing for 3 days, and the rates of retaining the MnO₄⁻concentration were calculated. Then, when the rate of retaining the MnO₄⁻ concentration after standing for 3 days with respect to the MnO₄⁻ concentration before standing for 3 days was 80% or more, it was evaluated as "○ (Good)", and when the rate of retaining the MnO₄⁻ concentration after standing for 3 days with respect to the MnO₄⁻concentration before standing for 3 days was less than 80%, it was evaluated as "× (Bad)". Here, the MnO₄⁻concentration in the abrasive slurry was evaluated as follows. First, the abrasive slurry is centrifuged (4,000 rpm × 20 min) to precipitate the manganese oxide abrasive grains in the abrasive slurry. Next, 1.0 g of the supernatant is separated, and pure water 109 is added thereto to dilute the supernatant, thus preparing a diluent. Then, the absorbance of MnO₄⁻ in the diluent was measured using a spectrophotometer (UH-4150 manufactured by Hitachi High-Tech Science Corporation), and the MnO₄⁻concentration was calculated by a calibration curve created in advance.

As shown in Fig. 1, the abrasive slurries according to Examples 1 to 9 were excellent in dispersibility since the particle sizes (D50) at a volume-based cumulative fraction of 50% in the particle size distribution obtained by the laser diffraction/scattering method before and after the addition of potassium permanganate which was the supply source of the permanganate ions were all 0.6 µm or less.

As for the abrasive slurries according to Examples 1 to 6 and 9, the state of adhesion of the abrasive slurry to the container containing the sample when the container was inverted was confirmed, and as a result, the sample did not adhere to the container, and the adhesion was very good. In addition, as for the abrasive slurries according to Examples 7 and 8, the state of adhesion of the abrasive slurry to the container containing the sample when the container was inverted was confirmed, and as a result, the sample adhered only to the bottom of the container, and the adhesion was good.

The polishing rates of the abrasive slurries according to Examples 1 to 9 were 0.10 µm/h or more, and thus, the abrasive slurries exhibited high polishing rates.

In the abrasive slurries according to Examples 1 to 9, the rates of retaining the MnO₄⁻ concentration were 80% or more after being left to stand at normal temperature (25°C) for 3 days, and thus it was possible to extend the pot life.

The invention disclosed in the present specification includes, in addition to the configurations of each of the inventions and the embodiments, those specified by changing these partial configurations to other configurations disclosed in the present specification, those specified by adding other configurations disclosed in the present specification to these configurations, or those specified by deleting these partial configurations to the extent that a partial action and effect can be obtained and forming a superordinate concept, to the extent applicable.

### Industrial Applicability

Since the abrasive slurry according to the present invention is excellent in dispersibility, exhibits a high polishing rate, and has a long pot life, the abrasive slurry is suitable as an abrasive for an object to be polished formed of a high hardness material. In addition, since the abrasive slurry according to the present invention is excellent in dispersibility, it leads to a reduction in environmental load from the viewpoint that a SiC substrate which is an object to be polished and a polishing pad are easily cleaned, and the amount of cleaning water used can be reduced, the viewpoint that the cleaning time can be shortened, and the viewpoint of that the amount of wastewater treated can be reduced. Furthermore, since the abrasive slurry according to the present invention exhibits a high polishing rate, the polishing treatment time can be shortened.

## Claims

1. An abrasive slurry comprising:
manganese oxide abrasive grains containing manganese oxide particles;
permanganate ions;
phosphates; and
a polymeric additive containing one or more water-soluble organic polymers selected from the group consisting of a polycarboxylic acid, a polycarboxylate, a salt of naphthalene sulfonic acid formalin condensate, polyvinyl alcohol, polyethylene glycose, polyvinylpyrrolidone, and copolymers thereof.

2. The abrasive slurry according to claim 1, wherein the polymeric additive is one or more water-soluble organic polymers selected from a polycarboxylic acid, a polycarboxylate, and copolymers thereof.

3. The abrasive slurry according to claim 2, wherein the polymeric additive is one or more water-soluble organic polymers selected from polyacrylic acid, a polyacrylate, and copolymers thereof.

4. The abrasive slurry according to claim 3, wherein the polymeric additive is ammonium polyacrylate.

5. The abrasive slurry according to claim 1, wherein the phosphates are pyrophosphate compounds.

6. The abrasive slurry according to any one of claims 1 to 5, wherein
the content of the manganese oxide abrasive grains is 0.5 mass% or more and 20 mass% or less,
the content of the permanganate ions is 0.5 mass% or more and 3.2 mass% or less,
the content of the phosphates is 0.001 mass% or more and 0.1 mass% or less, and
the content of the polymeric additive is 0.006 mass% or more and 0.05 mass% or less.

7. A polishing method comprising:
polishing an object to be polished using the abrasive slurry according to any one of claims 1 to 5.

8. A polishing method comprising:
polishing an object to be polished using the abrasive slurry according to claim 6.
